# EUROPÄISCHE PATENTSCHRIFT

(11) **EP 3 340 324 B1**
(45) Veröffentlichungstag und Bekanntmachung des Hinweises auf die Patenterteilung: **19.06.2019**
(21) Anmeldenummer: 17203024.9
(22) Anmeldetag: 22.11.2017
(51) Int. Cl.: H01L 41/047, G01L 1/16, H01L 41/083, H01L 41/277, H01L 41/293, H01L 41/297, H01L 41/113

(54) **MESSELEMENTSTAPEL ZUM MESSEN VON KRÄFTEN ODER DRÜCKEN UND VERFAHREN ZUR HERSTELLUNG EINES DERARTIGEN MESSELEMENTSTAPELS**
MEASURING ELEMENT STACK FOR MEASURING FORCES OR PRESSURES AND METHOD FOR PRODUCING SUCH A MEASURING ELEMENT STACK
EMPILEMENT D'ÉLÉMENT DE MESURE PERMETTANT DE MESURER LES PUISSANCES OU LES PRESSIONS ET PROCÉDÉ DE FABRICATION D'UN TEL EMPILEMENT D'ÉLÉMENT DE MESURE

(30) Priorität: 13.12.2016 AT 511302016
(43) Veröffentlichungstag der Anmeldung: 27.06.2018
(73) Patentinhaber: Piezocryst Advanced Sensorics GmbH, 8020 Graz (AT)
(72) Erfinder: STRMSEK, Robert, 2327 RACE (SI); BAUMGARTNER, Martin, 8522 GROSS ST. FLORIAN (AT); KROEGER, Dietmar, 8010 GRAZ (AT)
(74) Vertreter: Babeluk, Michael

(56) Entgegenhaltungen:
- WO-A1-2005/026678
- AT-B- 237 930
- AT-B- 389 170
- JP-A- S61 124 183
- US-A- 2 864 013

## Beschreibung

Die Erfindung betrifft einen Messelementstapel zum Messen von Kräften oder Drücken aus mehreren piezoelektrischen Kristallelementen, die unter Nutzung des transversalen Piezoeffektes mit jeweils entgegengerichteter elektrischer Polarisation gestapelt sind und an deren Seitenflächen Ableitelektroden aufweisen, wobei an gegenüberliegenden, der Krafteinleitung dienenden, ersten und zweiten Stirnflächen, die auf den Seitenflächen im Wesentlichen normal stehen, erste und zweite stirnseitige Elektroden angeordnet sind. Weiters betrifft die Erfindung ein Verfahren zur Herstellung eines derartigen Messelementstapels.

Aus der WO 2005/026678 A1 ist in diesem Zusammenhang ein Messelementstapel bekannt geworden, der aus mehreren, nebeneinander angeordneten, piezoelektrischen Kristallelementen besteht, bei welchen der Transversaleffekt genutzt wird. Die Kristallelemente weisen eine Dicke von ca. 0.5 mm auf und sind als Platten oder flache Quader ausgebildet. Alle sich unter Krafteinfluss elektrisch aufladenden Seitenflächen sind mit einer seitlichen Elektrode beschichtet. Abgesehen von den beiden äußeren, seitlichen Elektroden des Stapels verbinden die anderen, mittleren Ableitelektroden jeweils zwei benachbarte Kristallelemente fest miteinander. Die Verbindung durch die Ableitelektrode ist derart ausgebildet, dass sie sich unter der maximalen Last, welcher der Messelementstapel ausgesetzt werden soll und im gesamten, für den Stapel zugelassenen Temperaturbereich, nicht löst. Diese Verbindung kann beispielsweise mittels Bonden, Löten oder Thermokompression erreicht werden. Wichtig ist allerdings, dass zwei benachbarte Kristallelemente jeweils mit entgegengesetzten Polarisationsrichtungen angeordnet sind.

Zur Ladungsabnahme werden die unter Lasteinfluss Kraft aufnehmenden Stirnflächen der Kristallelemente ebenfalls mit einem elektrisch leitenden Material beschichtet. Dadurch entstehen die stirnflächigen Elektroden. Da die seitlichen Ableitelektroden während einer Messung jeweils alternierend entgegengesetzte Ladungen sammeln, ist darauf zu achten, dass benachbarte Ableitelektroden isoliert voneinander ausgeführt sind. Zu diesem Zweck werden die seitlichen Ableitelektroden alternierend von der oberen bzw. von der unteren stirnflächigen Elektrode getrennt.

Dies geschieht bei der WO 2005/026678 A1 durch das Anbringen einer kerbenartigen Fase am Übergang von der Seitenfläche zur Stirnfläche. Dadurch sammeln sich unter Lasteinfluss jeweils positive Ladungen auf der einen Stirnfläche und negative Ladungen auf der gegenüberliegenden Stirnfläche des Messelementstapels. An diesen, jeweils durch die kerbenartigen Fasen getrennten, stirnflächigen Elektroden kann die Ladungsabnahme von allen seitlichen Ableitelektroden erfolgen. Ein derart geschalteter Messelementstapel eignet sich zum Messen von axial, normal auf die Stirnflächen angreifenden Kräften oder Drücken.

Nachteilig bei diesem bekannten Konzept ist insbesondere die feste Verbindung der einzelnen Kristallelemente, über die durch Bonden, Löten oder Thermokompression verbundenen Ableitelektroden zwischen den benachbarten Kristallelementen, die insbesondere bei höheren Temperaturen zu Spannungen innerhalb des Messelementstapels und damit einhergehender Ablösung einzelner Ableitelektroden führen kann.

Weitere Vorrichtungen und Verfahren sind aus US 2 864 013, AT 237 930 B, AT 389 170 B und JP 61-124183 A bekannt.

Ein weiterer Nachteil besteht darin, dass durch die kerbartigen Fasen an den krafteinleitenden Stirnflächen eine Materialschwächung auftritt, die bei hoher Last oder raschem Lastwechsel zu einem Bruch einzelner Kristallelemente in diesem Bereich führen kann.

Aufgabe der Erfindung ist es, einen Messelementstapel zum Messen von Kräften oder Drücken bestehend aus mehreren piezoelektrischen Kristallelementen der eingangs beschriebenen Art derart zu verbessern, dass die oben genannten Nachteile vermieden werden und ein hochtemperaturfester, mit hohen Kräften und Drücken belastbarer, Messelementstapel realisierbar ist. Eine weitere Aufgabe besteht darin, ein möglichst einfaches Verfahren zur Herstellung eines derartigen Messelementstapels zu beschreiben.

Erfindungsgemäß wird dies dadurch erreicht, dass jede Ableitelektrode der einzelnen Kristallelemente auf den Seitenflächen durch einen elektrisch isolierenden Bereich in eine kleinere, an eine der beiden Stirnflächen angrenzende Randelektrode und eine größere Hauptelektrode unterteilt ist, wobei eine der Hauptelektroden des Kristallelements an dessen erste Stirnfläche angrenzt und die erste stirnseitige Elektrode kontaktiert und die andere Hauptelektrode an dessen zweite Stirnfläche angrenzt und die zweite stirnseitige Elektrode kontaktiert und wobei die Randelektroden benachbarter Ableitelektroden aneinander anliegen.

Bei der Erfindung werden ungleichnamige Ladungen der Ableitelektroden nicht durch stirnseitige Einkerbungen voneinander getrennt, sondern durch schmale, bevorzugt streifenförmige, isolierende Bereiche der Ableitelektroden, die jeweils eine schmale Randelektrode ausbilden, die entlang der Kante zur angrenzenden Stirnfläche verläuft.

Erfindungsgemäß bilden die ersten Stirnflächen und die daran angrenzenden Rand- und Hauptelektroden aller Kristallelemente des Messelementstapels eine ebene, geschlossene Auflagefläche für die erste stirnseitige Elektrode, wobei die zweiten Stirnflächen und die daran angrenzenden Rand- und Hauptelektroden aller Kristallelemente eine ebene, geschlossene Auflagefläche für die zweite stirnseitige Elektrode bilden, wobei die beiden Auflageflächen im Wesentlichen planparallel zueinander ausgebildet sind. Die ebenen Auflageflächen für die stirnseitigen Elektroden können auf einfache Weise hergestellt und beschichtet werden, da keine kerbartigen Fasen erforderlich sind.

Ein erfindungsgemäßes Verfahren zur Herstellung eines Messelementstapels zum Messen von Kräften oder Drücken aus mehreren piezoelektrischen Kristallelementen, die unter Nutzung des transversalen Piezoeffektes mit jeweils entgegengerichteter elektrischer Polarisation gestapelt werden, ist durch folgende Schritte gekennzeichnet:
a. Bereitstellen von im Wesentlichen quaderförmigen Kristallelementen mit parallelen Seitenflächen und gegenüberliegenden, ersten und zweiten Stirnflächen mit Rohabmessungen;
b. Aufbringen von Ableitelektroden auf beide Seitenflächen, wobei diese jeweils durch einen elektrisch isolierenden Bereich in eine kleinere, an eine der beiden Stirnflächen angrenzende Randelektrode und eine größere Hauptelektrode unterteilt werden, wobei die beiden Randelektroden an unterschiedlichen Stirnflächen des Kristallelements angrenzen;
c. Aneinanderreihen mehrerer Kristallelemente zu einem Messelementstapel, so dass die Randelektroden benachbarter Ableitelektroden aneinander anliegen;
d. Fixierung der Kristallelemente durch eine von außen angreifende Spanneinrichtung;
e. jeweils gemeinsame Bearbeitung der ersten und der zweiten Stirnflächen der Kristallelemente in der Spanneinrichtung durch Schleifen und oder Läppen zur Abtragung von Längenunterschieden einzelner Kristallelemente und zur Herstellung von zwei gegenüberliegenden, im Wesentlichen planparallelen Auflageflächen;
f. Aufbringen einer ersten stirnseitigen Elektrode auf die erste Auflagefläche und einer zweiten stirnseitigen Elektrode auf die zweite Auflagefläche; sowie
g. Entfernen der Spanneinrichtung vom Messelementstapel.

Beim erfindungsgemäßen Verfahren müssen die einzelnen Kristallelemente vor der Beschichtung nicht auf exakte Abmessungen zugeschnitten werden, eine Rohabmessung reicht, wobei beispielsweise Längenunterschiede der einzelnen Kristallelemente von wenigen Millimetern zulässig sind. Diese Längenunterschiede werden gemäß Punkt d. bei der gemeinsamen Bearbeitung der ersten und der zweiten Stirnflächen der Kristallelemente durch Schleifen und oder Läppen ausgeglichen.

Die Erfindung wird im Folgenden anhand von Ausführungsbeispielen näher erläutert. Es zeigen:
- Fig. 1: einen erfindungsgemäßen Messelementstapel zum Messen von Kräften oder Drücken bestehend aus mehreren piezoelektrischen Kristallelementen in einer Schnittdarstellung,
- Fig. 2: bis Fig. 5 unterschiedliche Stadien während des Herstellungsverfahrens eines Messelementstapels gemäß Fig. 1
- Fig. 6: eine Ausführungsvariante eines erfindungsgemäßen Messelementstapel in einer Schnittdarstellung gemäß Fig. 1, sowie
- Fig. 7: und Fig. 8 unterschiedliche Stadien während des Herstellungsverfahrens eines Messelementstapels gemäß Fig. 6.

Funktionsgleiche Teile sind in den einzelnen Ausführungsvarianten mit gleichen Bezugszeichen versehen.

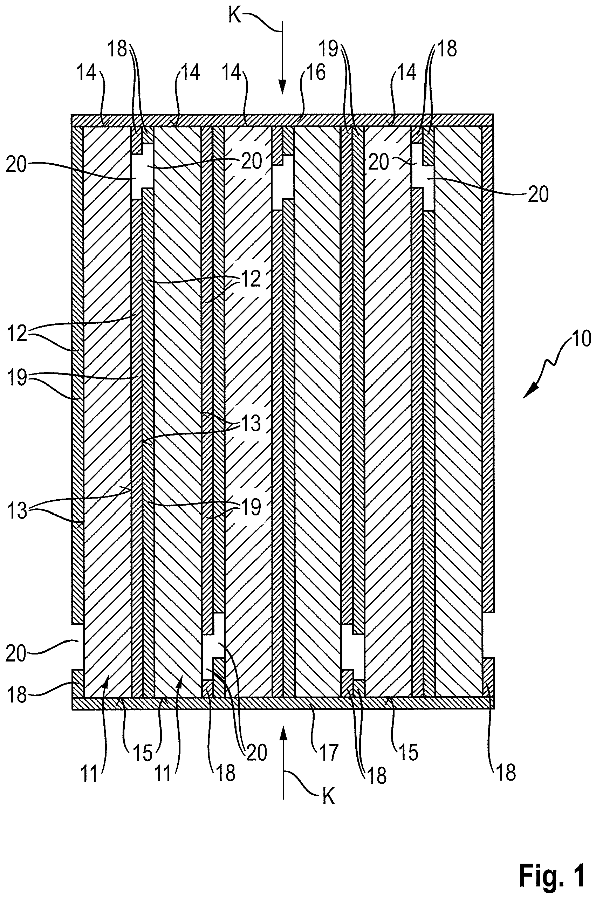

Der Messelementstapel 10 gemäß Fig. 1 besteht aus mehreren, quaderförmigen, piezoelektrischen Kristallelementen 11, die unter Nutzung des transversalen Piezoeffektes mit jeweils entgegengerichteter, elektrischer Polarisation gestapelt sind und deren unter Krafteinfluss elektrische Ladungen generierende Seitenflächen 13 Ableitelektroden 12 aufweisen. An gegenüberliegenden, der Krafteinleitung (siehe Pfeile K) dienenden, ersten und zweiten Stirnflächen 14, 15, die auf die Seitenflächen 13 im Wesentlichen normal stehen, sind erste und zweite stirnseitige Elektroden 16, 17 angeordnet, die jeweils im Wesentlichen die obere bzw. untere Deckfläche des Messelementstapels 10 abdecken. Die Schichtdicke der stirnseitigen Elektroden 16, 17 kann zum Rand hin reduziert bzw. abgerundet sein.

Die Schichtdicke der Ableitelektroden 12 und der stirnseitigen Elektroden 16, 17 ist im Vergleich zu den Abmessungen der Kristallelemente 11 überhöht dargestellt, um Details besser sichtbar zu machen.

Die Ableitelektroden 12 sind durch elektrisch isolierende Bereiche 20 asymmetrisch jeweils in eine kleinere, an eine der beiden Stirnflächen 14, 15 angrenzende Randelektrode 18 und eine größere Hauptelektrode 19 unterteilt, wobei eine der Hauptelektroden 19 des Kristallelements 11 an dessen erste Stirnfläche 14 angrenzt und die erste stirnseitige Elektrode 16 kontaktiert und die andere Hauptelektrode 19 an dessen zweite Stirnfläche 15 angrenzt und die zweite stirnseitige Elektrode 17 kontaktiert.

Bei der Erfindung wird darauf geachtet, dass die Randelektrode 18 und der elektrisch isolierende Bereich 20 zusammen weniger als 20%, bevorzugt weniger als 5% bis 10%, der Seitenfläche 13 des Kristallelements 11 beanspruchen, um den nicht zum Messsignal beitragenden Randbereich des Kristallelements 11, in welchem sich die Ladungen kompensieren, klein zu halten.

Die ersten Stirnflächen 14 der gestapelten Kristallelemente 11 und die daran angrenzenden Rand- und Hauptelektroden 18, 19 aller Kristallelemente 11 des Messelementstapels 10 bilden eine ebene, geschlossene Auflagefläche für die erste stirnseitige Elektrode 16. Gleiches gilt für die zweiten Stirnflächen 15 und die daran angrenzenden Rand- und Hauptelektroden 18, 19 aller Kristallelemente 11, die eine ebene, geschlossene Auflagefläche für die zweite stirnseitige Elektrode 17 bilden, wobei die beiden Auflageflächen planparallel zueinander ausgebildet sind.

Die Kristallelemente 11 weisen somit zwischen den beiden gegenüberliegenden Stirnflächen 14, 15 einen im Wesentlichen einheitlichen Querschnitt auf, der nicht - wie beim Stand der Technik - durch eine stirnseitige Ausbildung von Rundungen und Fasen an den Kanten der Kristallelemente geschwächt ist.

Erfindungsgemäß können die stirnseitigen Elektroden 16, 17 in einer Dicke von 1 bis 20 µm, vorzugsweise von 2 µm bis 4 µm, ausgeführt sein und dienen zumindest bei der Montage des Messelementstapels 10, beispielsweise in einem Drucksensor, für den seitlichen Zusammenhalt der Kristallelemente 11. Eine feste Verbindung der seitlichen Ableitelektroden 12 durch Löten oder Bonden ist daher weder erforderlich noch erwünscht.

Bei der Herstellung eines erfindungsgemäßen Messelementstapels werden zunächst im Wesentlichen plattenförmige bzw. quaderförmige Kristallelemente 11 mit parallelen Seitenflächen 13 und gegenüberliegenden ersten und zweiten Stirnflächen 14, 15 mit Rohabmessungen ausgeschnitten, d.h. es ist nicht erforderlich, dass die Kristallelemente 11 exakt die gleiche Länge (zwischen den Stirnseiten 14, 15), Breite oder Dicke aufweisen.

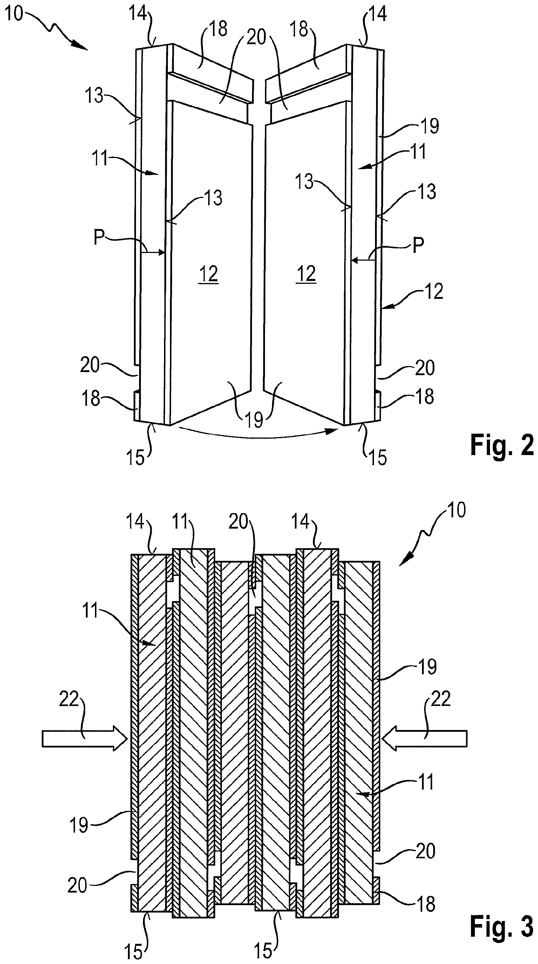

Danach werden gemäß Fig. 2 auf beide Seitenflächen 13 Ableitelektroden 12 aufgebracht, wobei diese jeweils durch einen elektrisch isolierenden Bereich 20 in eine kleinere, an eine der beiden Stirnflächen 14, 15 angrenzende Randelektrode 18 und eine größere Hauptelektrode 19 unterteilt werden, wobei die beiden Randelektroden 18 an unterschiedlichen Stirnflächen 14, 15 des jeweiligen Kristallelements 11 angrenzen.

Zur Nutzung des transversalen Piezoeffektes werden die Kristallelemente 11 so gestapelt, dass die unter Krafteinwirkung entstehende elektrische Polarisation P jeweils entgegengerichtet ist, wobei die Randelektroden 18 benachbarter Ableitelektroden 12 aneinander anliegen. Es entsteht somit der in Fig. 3 dargestellte Messelementstapel 10, in welchem die einzelnen Kristallelemente 11 noch geringfügig unterschiedliche Längen (überhöht dargestellt) aufweisen und zur gemeinsamen Bearbeitung seitlich, d.h. normal auf die Ableitelektroden 12 gerichtet, zusammengespannt werden (siehe Pfeile 22).

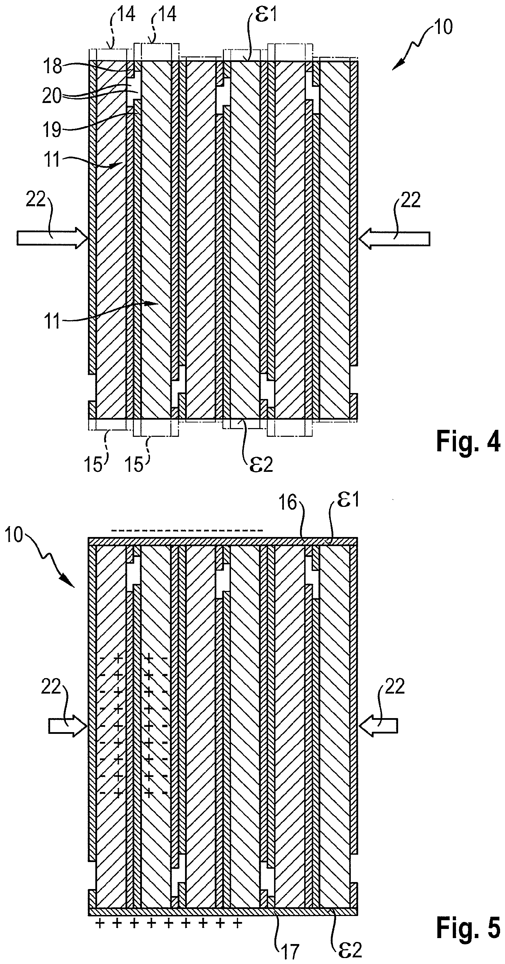

Gemäß Fig. 4 erfolgt danach eine gemeinsame Bearbeitung der ersten 14 und der zweiten Stirnflächen 15 der Kristallelemente 11 durch Schleifen und oder Läppen zur Abtragung von Längenunterschieden einzelner Kristallelemente 11 und zur Herstellung von zwei gegenüberliegenden, planparallelen Auflageflächen ε1 und ε2.

In einem letzten Schritt werden gemäß Fig. 5 eine erste stirnseitige Elektrode 16 auf die erste Auflagefläche ε1 und eine zweite stirnseitigen Elektrode 17 auf die zweite Auflagefläche ε2 aufgetragen. Das Ergebnis ist der Messelementstapel 10 gemäß Fig. 1.

Die isolierenden Bereiche 20 benachbarter Ableitelektroden 12 können spiegelgleich oder aufgrund unterschiedlicher Längen einzelner Kristallelemente 11 geringfügig zueinander versetzt angeordnet sein. Jedenfalls muss dafür gesorgt sein, dass ein elektrischer Kontakt zwischen der Randelektrode 18 eines Kristallelements 11 und der Hauptelektrode 19 des benachbarten Kristallelements 11 unterbunden bleibt.

Der streifenförmige, elektrisch isolierende Bereich 20 kann durch entsprechende Maskierung bei der Aufbringung der Ableitelektrode 12, beispielsweise durch Sputtern, Aufdampfen oder Vacuum Deposition hergestellt werden.

Es ist auch möglich den elektrisch isolierenden Bereich 20 durch nachträgliches Ätzen, Fräsen, Schleifen oder durch Laserablation der Ableitelektrode 12 herzustellen, wobei darauf geachtet werden muss, die Seitenflächen 13 des Kristallelements 11 schonend zu behandeln.

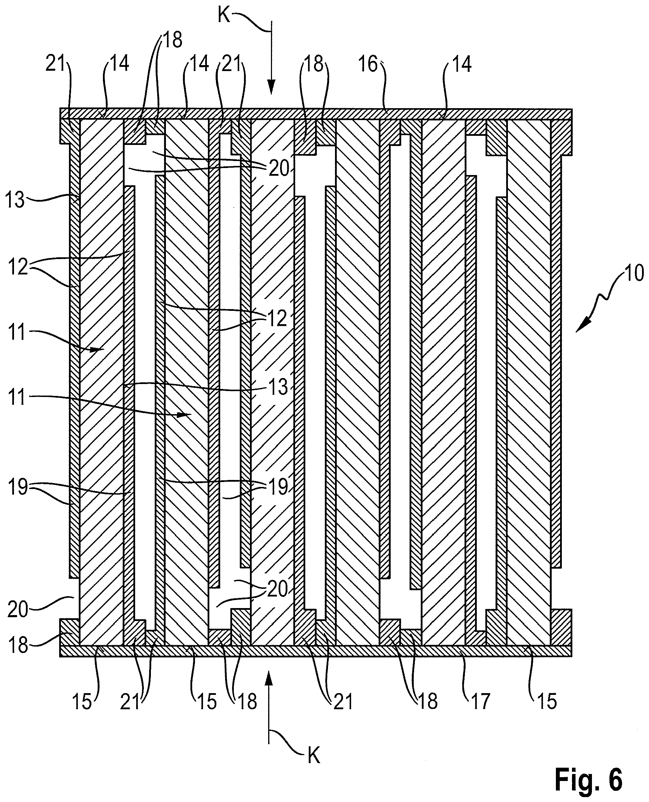

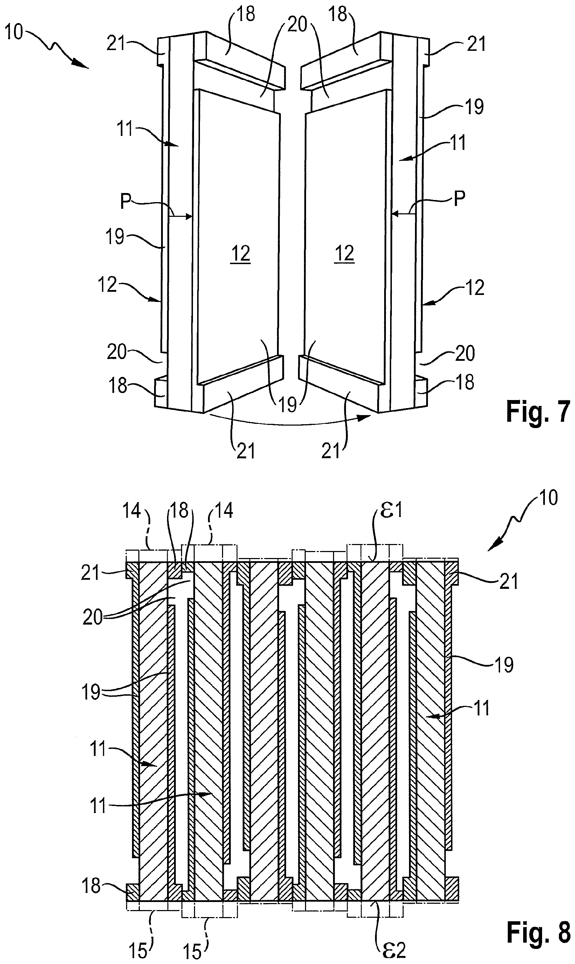

Die in Fig. 6 dargestellte Ausführungsvariante der Erfindung unterscheidet sich von jener nach Fig. 1 dadurch, dass die Randelektrode 18 und der stirnseitige Randbereich 21 der Hauptelektrode 19 eine größere Materialdicke, beispielsweise die doppelte Materialdicke, als der verbleibende Teil der Hauptelektrode 19 aufweisen (überhöht dargestellt), sodass benachbarten Ableitelektroden 12 im Messelementstapel 10 - bis auf die beiden stirnseitigen Bereiche - voneinander beabstandet sind (siehe Fig. 6, Fig. 8). Durch diese Maßnahme kann ein Kontakt benachbarter Ableitelektroden 12 im Messbetrieb selbst bei hoher Temperatur und hohen Kräften bzw. raschen Lastwechseln weitgehend ausgeschlossen werden.

Die Herstellung eines Messelementstapels gemäß Fig. 6 verläuft im Wesentlichen analog dem bereits beschriebenen Herstellungsverfahren zum Stapel gemäß Fig. 1.

Beim Aufbringen der Ableitelektroden 12 muss darauf geachtet werden, dass die stirnseitige Randelektrode 18 und ein stirnseitiger Randbereich 21 der Hauptelektrode 19 mit größerer Materialdicke ausgeführt werden, als der verbleibende Teil der Hauptelektrode 19 (siehe Fig. 7).

Nach dem Zusammenfügen der Kristallelemente 11 erfolgt - wie bereits oben beschrieben - eine gemeinsame Bearbeitung der ersten und der zweiten Stirnflächen 14, 15 der Kristallelemente 11 durch Schleifen und oder Läppen zur Abtragung von Längenunterschieden einzelner Kristallelemente 11 und zur Herstellung von zwei gegenüberliegenden, planparallelen Auflageflächen ε1 und ε2 (siehe Fig. 8). Nach dem Aufbringen der stirnseitigen Elektroden 16, 17 entsteht der in Fig. 6 dargestellte Messelementstapel 10.

Durch das Aufbringen der stirnseitigen Elektroden 16, 17 auf die planparallelen Auflageflächen ε1 und ε2 kann der Messelementstapel 10 zumindest bis zur Montage in einer Vorrichtung zum Messen von Kräften oder Drücken, beispielsweise einem Drucksensor, zusammengehalten werden.

Die Messgenauigkeit des erfindungsgemäßen Messelementstapels 10 wird erhöht, da die der Krafteinleitung dienenden Flächen ε1 und ε2 (siehe Fig. 4, Fig. 5) in einem Arbeitsgang gemeinsam hergestellt werden können.

## Patentansprüche

1. Messelementstapel (10) zum Messen von Kräften oder Drücken aus mehreren piezoelektrischen Kristallelementen (11), die unter Nutzung des transversalen Piezoeffektes mit jeweils entgegengerichteter elektrischer Polarisation gestapelt sind und an deren Seitenflächen (13) Ableitelektroden (12) aufweisen, wobei an gegenüberliegenden, der Krafteinleitung dienenden, ersten und zweiten Stirnflächen (14, 15), die auf den Seitenflächen (13) im Wesentlichen normal stehen, erste und zweite stirnseitige Elektroden (16, 17) angeordnet sind, **dadurch gekennzeichnet, dass** jede Ableitelektrode (12) durch einen elektrisch isolierenden Bereich (20) in eine kleinere, an eine der beiden Stirnflächen (14, 15) angrenzende Randelektrode (18) und eine größere Hauptelektrode (19) unterteilt ist, wobei eine der Hauptelektroden (19) des Kristallelements (11) an dessen erste Stirnfläche (14) angrenzt und die erste stirnseitige Elektrode (16) kontaktiert und die andere Hauptelektrode (19) an dessen zweite Stirnfläche (15) angrenzt und die zweite stirnseitige Elektrode (17) kontaktiert und wobei die Randelektroden (18) benachbarter Ableitelektroden (12) aneinander anliegen.

2. Messelementstapel (10) nach Anspruch 1, **dadurch gekennzeichnet, dass** die isolierenden Bereiche (20) benachbarter Ableitelektroden (12) spiegelgleich oder geringfügig zueinander versetzt angeordnet sind, derart, dass ein elektrischer Kontakt zwischen der Randelektrode (18) eines Kristallelements (11) und der Hauptelektrode (19) des benachbarten Kristallelements (11) unterbunden ist.

3. Messelementstapel (10) nach Anspruch 1 oder 2, **dadurch gekennzeichnet, dass** die ersten Stirnflächen (14) und die daran angrenzenden Rand- und Hauptelektroden (18, 19) aller Kristallelemente (11) des Messelementstapels (10) eine ebene, geschlossene Auflagefläche für die erste stirnseitige Elektrode (16) bilden, dass die zweiten Stirnflächen (15) und die daran angrenzenden Rand- und Hauptelektroden (18, 19) aller Kristallelemente (11) eine ebene, geschlossene Auflagefläche für die zweite stirnseitige Elektrode (17) bilden, wobei die beiden Auflageflächen im Wesentlichen planparallel zueinander ausgebildet sind.

4. Messelementstapel (10) nach einem der Ansprüche 1 bis 3, **dadurch gekennzeichnet, dass** die Randelektrode (18) und der stirnseitige Randbereich (21) der Hauptelektrode (19) eine größere Materialdicke, beispielsweise die doppelte Materialdicke, als der verbleibende Teil der Hauptelektrode (19) aufweisen, sodass benachbarte Ableitelektroden (12) im Messelementstapel (10) - bis auf die beiden stirnseitigen Bereiche - voneinander beabstandet sind.

5. Messelementstapel (10) nach einem der Ansprüche 1 bis 4, **dadurch gekennzeichnet, dass** die Randelektrode (18) und der elektrisch isolierende Bereich (20) zusammen weniger als 20%, bevorzugt weniger als 5% bis 10%, der Seitenfläche (13) des Kristallelements (11) beanspruchen.

6. Messelementstapel (10) nach einem der Ansprüche 1 bis 5, **dadurch gekennzeichnet, dass** die Kristallelemente (11) zwischen den beiden gegenüberliegenden Stirnflächen (14, 15) einen im Wesentlichen einheitlichen Querschnitt aufweisen, ohne stirnseitige Ausbildung von Rundungen und Fasen an den Kanten.

7. Messelementstapel (10) nach einem der Ansprüche 1 bis 6, **dadurch gekennzeichnet, dass** die stirnseitigen Elektroden (16, 17) in einer Dicke von 1 µm bis 20 µm, vorzugsweise von 2 µm bis 4 µm, ausgeführt sind und zumindest bei der Montage des Messelementstapels (10) für den Zusammenhalt der Kristallelemente (11) dienen.

8. Verfahren zur Herstellung eines Messelementstapels (10) zum Messen von Kräften oder Drücken aus mehreren piezoelektrischen Kristallelementen (11), die unter Nutzung des transversalen Piezoeffektes mit jeweils entgegengerichteter elektrischer Polarisation gestapelt werden, **gekennzeichnet durch** folgende Schritte:
a. Bereitstellen von im Wesentlichen quaderförmigen Kristallelementen (11) mit parallelen Seitenflächen (13) und gegenüberliegenden ersten und zweiten Stirnflächen (14, 15) mit Rohabmessungen;
b. Aufbringen von Ableitelektroden (12) auf beide Seitenflächen (13), wobei diese jeweils durch einen elektrisch isolierenden Bereich (20) in eine kleinere, an eine der beiden Stirnflächen (14, 15) angrenzende Randelektrode (18) und eine größere Hauptelektrode (19) unterteilt werden, wobei die beiden Randelektroden (18) an unterschiedlichen Stirnflächen (14, 15) des Kristallelements (11) angrenzen;
c. Aneinanderreihen mehrerer Kristallelemente (11) zu einem Messelementstapel (10), so dass die Randelektroden(18) benachbarter Ableitelektroden (12) aneinander anliegen;
d. Fixierung der Kristallelemente (11) durch eine von außen angreifende Spanneinrichtung;
e. jeweils gemeinsame Bearbeitung der ersten (14) und der zweiten Stirnflächen (15) der Kristallelemente (11) in der Spanneinrichtung durch Schleifen und oder Läppen zur Abtragung von Längenunterschieden einzelner Kristallelemente (11) und zur Herstellung von zwei gegenüberliegenden, im Wesentlichen planparallelen Auflageflächen;
f. Aufbringen einer ersten stirnseitigen Elektrode (16) auf die erste Auflagefläche und einer zweiten stirnseitigen Elektrode (17) auf die zweite Auflagefläche; sowie
g. Entfernen der Spanneinrichtung vom Messelementstapel (10).

9. Verfahren nach Anspruch 8, **dadurch gekennzeichnet, dass** der elektrisch isolierende Bereich (20) gemäß Schritt b. durch Maskierung bei der Aufbringung der Ableitelektrode (12) durch Sputtern, Aufdampfen oder Vacuum Deposition hergestellt wird.

10. Verfahren nach Anspruch 8, **dadurch gekennzeichnet, dass** der elektrisch isolierende Bereich (20) gemäß Schritt b. durch nachträgliches Ätzen, Fräsen, Schleifen oder durch Laserablation hergestellt wird.

11. Verfahren nach einem der Ansprüche 8 bis 10, **dadurch gekennzeichnet, dass** anschließend an Schritt b. oder im Schritt b. die stirnseitige Randelektrode (18) und ein stirnseitiger Randbereich (21) der Hauptelektrode (19) mit größerer Materialdicke ausgeführt werden, als der verbleibende Teil der Hauptelektrode (19).

12. Verfahren nach einem der Ansprüche 8 bis 11, **dadurch gekennzeichnet, dass** der Messelementstapel (10) durch das Aufbringen der stirnseitigen Elektroden (16, 17) gemäß Schritt e. zumindest bis zur Montage des Messelementstapels (10) in einer Vorrichtung zum Messen von Kräften oder Drücken, beispielsweise einem Drucksensor, zusammengehalten wird.

## Claims

1. Measuring element stack (10) for measuring forces or pressures, made from a plurality of piezoelectric crystal elements (11) which by using the transverse piezoelectric effect are stacked with in each case oppositely directed electrical polarization and have discharge electrodes (12) on their side faces (13), wherein first and second end face electrodes (16, 17) are arranged on opposite first and second end faces (14, 15) which serve to introduce the force and are essentially normal on the side faces (13), **characterised in that** each discharge electrode (12) is divided by an electrically insulating region (20) into a smaller edge electrode (18) adjoining one of the two end faces (14, 15) and a larger main electrode (19), wherein one of the main electrodes (19) of the crystal element (11) adjoins its first end face (14) and contacts the first end face electrode (16) and the other main electrode (19) adjoins its second end face (15) and contacts the second end face electrode (17), and wherein the edge electrodes (18) of adjacent discharge electrodes (12) abut one another.

2. Measuring element stack (10) according to claim 1, **characterised in that** the insulating regions (20) of adjacent discharge electrodes (12) are arranged mirror-inverted or slightly offset with respect to one another in such a way that an electrical contact between the edge electrode (18) of a crystal element (11) and the main electrode (19) of the adjacent crystal element (11) is prevented.

3. Measuring element stack (10) according to claim 1 or 2, **characterised in that** the first end faces (14) and the edge and main electrodes (18, 19) of all crystal elements (11) of the measuring element stack (10) adjoining said first end faces form a flat, closed bearing surface for the first end face electrode (16), **in that** the second end faces (15) and the edge and main electrodes (18, 19) of all crystal elements (11) adjoining said second end faces form a flat, closed bearing surface for the second end face electrode (17), wherein the two bearing surfaces are formed essentially plane-parallel to one another.

4. Measuring element stack (10) according to one of claims 1 to 3, **characterised in that** the edge electrode (18) and the end face edge region (21) of the main electrode (19) have a greater material thickness, for example twice the material thickness, than the remaining part of the main electrode (19), so that adjacent discharge electrodes (12) in the measuring element stack (10) are spaced apart from one another - except for the two end face regions.

5. Measuring element stack (10) according to one of claims 1 to 4, **characterised in that** the edge electrode (18) and the electrically insulating region (20) together occupy less than 20%, preferably less than 5% to 10%, of the side surface (13) of the crystal element (11).

6. Measuring element stack (10) according to one of claims 1 to 5, **characterised in that** the crystal elements (11) have a substantially uniform cross-section between the two opposing end faces (14, 15), without the formation of rounded portions and chamfers at the edges on the end faces.

7. Measuring element stack (10) according to one of claims 1 to 6, **characterised in that** the end face electrodes (16, 17) are designed in a thickness of 1 µm to 20 µm, preferably of 2 µm to 4 µm, and serve at least during the assembly of the measuring element stack (10) for the cohesion of the crystal elements (11).

8. Method for producing a measuring element stack (10) for measuring forces or pressures, made from a plurality of piezoelectric crystal elements (11) which are stacked by using the transverse piezoelectric effect with opposite electric polarization in each case, **characterised by** the following steps:
a) providing substantially parallelepipedal crystal elements (11) having parallel side faces (13) and opposite first and second end faces (14, 15) having raw dimensions;
b) applying discharge electrodes (12) to both side surfaces (13), wherein these are each divided by an electrically insulating region (20) into a smaller edge electrode (18) adjoining one of the two end faces (14, 15) and a larger main electrode (19), wherein the two edge electrodes (18) adjoin different end faces (14, 15) of the crystal element (11);
c) lining up a plurality of crystal elements (11) one after the other to form a measuring element stack (10), so that the edge electrodes (18) of adjacent discharge electrodes (12) abut one another;
d) fixing the crystal elements (11) by an externally acting clamping device;
e) in each case joint machining of the first (14) and the second end faces (15) of the crystal elements (11) in the clamping device by grinding and/or lapping for removing length differences of individual crystal elements (11) and for producing two opposing, substantially plane-parallel bearing surfaces;
f) applying a first end face electrode (16) to the first bearing surface and a second end face electrode (17) to the second bearing surface; and
g) removing the clamping device from the measuring element stack (10).

9. Method according to claim 8, **characterised in that** the electrically insulating region (20) according to step b) is produced by masking during the application of the discharge electrode (12) by sputtering, vapor deposition or vacuum deposition.

10. Method according to claim 8, **characterised in that** the electrically insulating region (20) according to step b) is produced by subsequent etching, milling, grinding or laser ablation.

11. Method according to one of claims 8 to 10, **characterised in that**, following step b) or in step b), the end face edge electrode (18) and an end face edge region (21) of the main electrode (19) are formed with greater material thickness than the remaining part of the main electrode (19).

12. Method according to one of claims 8 to 11, **characterised in that** the measuring element stack (10) is held together by applying the end face electrodes (16, 17) according to step e) at least until assembly of the measuring element stack (10) in a device for measuring forces or pressures, for example a pressure sensor.

## Revendications

1. Empilement d'éléments de mesure (10) permettant de mesurer des forces ou des pressions constitué de plusieurs éléments cristallins, piézoélectriques (11) qui sont empilés, en utilisant l'effet piézoélectrique transversal avec respectivement des polarisations électriques dirigées en sens inverse et qui comportent des électrodes de référence (12) sur leurs faces latérales (13), empilement dans lequel, sur les premières et les secondes faces frontales (14, 15) qui sont opposées et servent à introduire la force, et sont essentiellement perpendiculaires aux faces latérales (13) sont montées des premières et des secondes électrodes frontales (16, 17),
**caractérisé en ce que**
chaque électrode de référence (12) est subdivisée par une zone (20) électriquement isolante en une électrode de bord (18) plus petite, adjacente à l'une des deux faces frontales (14, 15) et une électrode principale (19) plus grande, et l'une des électrodes principales (19) de l'élément cristallin (11) est adjacente à sa première face frontale (14) et vient en contact avec la première électrode frontale (16) tandis que l'autre électrode principale (19) est adjacente à sa seconde face frontale (15) et vient en contact avec la seconde électrode frontale (17), les électrodes de bord (18) d'électrodes de référence voisines (12) s'appliquant l'une sur l'autre.

2. Empilement d'éléments de mesure (10) conforme à la revendication 1,
**caractérisé en ce que**
les zones isolantes (20) d'électrodes de référence voisines (12) présentent une symétrie de miroir ou sont un peu décalées l'une par rapport à l'autre de sorte qu'un contact électrique entre l'électrode de bord (18) d'un élément cristallin (11) et l'électrode principale (19) de l'élément cristallin voisin (11) soit empêché.

3. Empilement d'éléments de mesure (10) conforme à la revendication 1 ou 2,
**caractérisé en ce que**
les premières faces frontales (14) et les électrodes de bord et les électrodes principales (18, 19) adjacentes à celles-ci de tous les éléments cristallins (11) de l'empilement d'éléments de mesure (10) forment une surface d'appui fermée plane pour la première électrode frontale (16), les secondes faces frontales (15) et les électrodes de bord et les électrodes principales (18, 19) adjacentes à celles-ci de tous les éléments cristallins (11) forment une surface d'appui fermée plane pour la seconde électrode frontale (17), les deux surfaces d'appui étant essentiellement planes et parallèles l'une à l'autre.

4. Empilement d'éléments de mesure (10) conforme à l'une des revendications 1 à 3,
**caractérisé en ce que**
l'électrode de bord (18) et la zone de bord frontale (21) de l'électrode principale (19) ont une plus grande épaisseur de matériau, à titre d'exemple égale au double de l'épaisseur de matériau de la partie restante de l'électrode principale (19) de sorte que des électrodes de référence (12) voisines dans l'empilement d'éléments de mesure (10) soient situées à distance jusque sur les deux zones frontales.

5. Empilement d'éléments de mesure (10) conforme à l'une des revendications 1 à 4,
**caractérisé en ce que**
l'électrode de bord (18) et la zone électriquement isolante (20) occupent conjointement moins de 20 %, de préférence moins de 5 % à 10 % de la face latérale (13) de l'élément cristallin (11).

6. Empilement d'éléments de mesure (10) conforme à l'une des revendications 1 à 5,
**caractérisé en ce que**
les éléments cristallins (11) ont, entre les deux faces frontales opposées (14, 15) une section essentiellement unitaire sans formation frontale d'arrondis et de biseaux au niveau des arrêtes.

7. Empilement d'élément de mesure (10) conforme à l'une des revendications 1 à 6,
**caractérisé en ce que**
les électrodes frontales (16, 17) sont réalisées avec une épaisseur de 1 µm à 20 µm, de préférence de 2 µm à 4 µm, et servent au moins lors du montage de l'empilement d'éléments (10) de mesure au maintien des éléments cristallins (11).

8. Procédé d'obtention d'un empilement d'éléments de mesure (10) permettant de mesurer des forces et des pressions constitué de plusieurs éléments cristallins piézoélectriques (11) qui sont empilés en utilisant l'effet piézoélectrique transversal respectivement avec des polarisations électriques dirigées en sens inverse,
**caractérisé en ce qu'**
il comporte les étapes suivantes consistant à :
a. se procurer des éléments cristallins essentiellement en forme de parallélépipèdes (11) ayant des faces latérales (13) parallèles et des premières et des secondes faces frontales (14, 15) opposées ayant des dimensions brutes,
b. appliquer des électrodes de référence (12) sur les deux faces frontales (13), celles-ci étant respectivement subdivisées par une zone électriquement isolante (20) en une électrode de bord (18) plus petite adjacente à l'une des deux faces frontales (14, 15) et en une électrode principale (19) plus grande, les deux électrodes de bord (18) étant adjacentes à différentes faces frontales (14, 15) de l'élément cristallin (11),
c. aligner plusieurs éléments cristallins (11) en une pile d'éléments de mesure (10) de sorte que les électrodes de bord (18) d'électrodes de référence (12) voisines soient appliquées l'une contre l'autre,
d. fixer les éléments cristallins (11) par un dispositif de serrage venant en prise par l'extérieur,
e. usiner respectivement conjointement les premières faces frontales (14) et les secondes faces frontales (15) des éléments cristallins (11) dans le dispositif de serrage par rectification et/ou rodage pour supprimer des différences de longueur entre les éléments cristallins (11) individuels et pour obtenir deux surfaces d'appui opposées essentiellement parallèles et planes,
f. appliquer en place une première électrode frontale (16) sur la première face d'appui et une seconde électrode frontale (17) sur la seconde face d'appui, et
g. enlever le dispositif de serrage de l'empilement d'éléments de mesure (10).

9. Procédé conforme à la revendication 8,
**caractérisé en ce que**
la zone électriquement isolante (20) de l'étape b est obtenue par masquage lors de l'application de l'électrode de référence (12) par pulvérisation cathodique, vaporisation ou dépôt sous vide.

10. Procédé conforme à la revendication 8,
**caractérisé en ce que**
la zone électriquement isolante (20) de l'étape b est obtenue par attaque chimique, fraisage, ou rectification ultérieur ou par ablation au laser.

11. Procédé conforme à l'une des revendications 8 à 10,
**caractérisé en ce qu'**
à la suite de l'étape b ou lors de l'étape b, l'électrode de bord frontale (18) et une zone de bord frontale (21) de l'électrode principale (19) sont réalisées avec une plus grande épaisseur de matériau que la partie restante de l'électrode principale (19).

12. Procédé conforme à l'une des revendications 8 à 11,
**caractérisé en ce que**
l'empilement d'éléments de mesure (10) est maintenu par l'application des électrodes frontales (16, 17) selon l'étape e au moins jusqu'au montage de l'empilement d'éléments de mesure (10) dans un dispositif de mesure de forces ou de pressions, à titre exemple un détecteur de pression.
